# EUROPÄISCHE PATENTSCHRIFT

(11) **EP 1 966 578 B1**
(45) Veröffentlichungstag und Bekanntmachung des Hinweises auf die Patenterteilung: **14.11.2012**
(21) Anmeldenummer: 06819667.4
(22) Anmeldetag: 22.11.2006
(51) Int. Cl.: G01L 9/00

(54) **MIKROMECHANISCHER KAPAZITIVER DRUCKWANDLER UND HERSTELLUNGSVERFAHREN**
MICROMECHANICAL CAPACITIVE PRESSURE TRANSDUCER AND PRODUCTION METHOD
TRANSDUCTEUR DE PRESSION CAPACITIF MICROMECANIQUE ET SON PROCEDE DE FABRICATION

(30) Priorität: 20.12.2005 DE 102005060855
(43) Veröffentlichungstag der Anmeldung: 10.09.2008
(73) Patentinhaber: ROBERT BOSCH GMBH, 70442 Stuttgart (DE)
(72) Erfinder: BENZEL, Hubert, 72124 Pliezhausen (DE); ARMBRUSTER, Simon, 72810 Gomaringen (DE); LAMMEL, Gerhard, 72070 Tuebingen (DE); SCHELLING, Christoph, 72762 Reutlingen (DE); BRASAS, Joerg, 72141 Walddorfhaeslach (DE)
(86) Internationale Anmeldenummer: PCT/EP2006/068758
(87) Internationale Veröffentlichungsnummer: WO 2007/071515

(56) Entgegenhaltungen:
- WO-A-2005/077815
- DE-A1- 4 410 631
- US-A- 5 177 661

## Beschreibung

Die Erfindung betrifft ein Verfahren zur Herstellung eines mikromechanischen kapazitiven Druckwandlers bzw. ein mit diesem Verfahren hergestelltes mikromechanisches Bauelement nach den Oberbegriffen der unabhängigen Ansprüche.

### Stand der Technik

Aus der Schrift DE 101 14 036 A1 ist ein Verfahren zur Herstellung von mikromechanischen Sensoren bekannt. Dabei werden in ein Halbleitersubstrat Öffnungen eingebracht, die sich bei einer nachfolgenden Temperaturbehandlung in der Tiefe des Substrats zu Hohlräumen unter einer geschlossenen Membrandecke umwandeln. Mit diesem Verfahren ist ein kapazitiver Drucksensor herstellbar, wobei der Hohlraum zwischen zwei Dotierungszonen im Substrat erzeugt wird. Werden diese beiden Zonen elektrisch voneinander isoliert, bilden sie einen Plattenkondensator, dessen Kapazität von dem Abstand der Dotierungszonen abhängt. Durch eine Tiefenkontaktierung lassen sich beide Dotierungszonen elektrisch mit einer entsprechende Auswerteschaltung verbinden. Eine Verformung des Halbleitersubstrats kann so in eine messbare Änderung der Kapazität umgewandelt werden. Das Messergebnis ergibt sich dabei als Verhältnis des Umgebungsdrucks relativ zum Druck im Hohlraum. Das dort beschriebene Sensorelement hat den Nachteil, dass die beiden Elektroden lediglich über pn-Übergänge voneinander isoliert sind, welche Parasitärkapazitäten darstellen und zu unerwünschten Leckströmen führen.

Ein weiteres Verfahren zur Herstellung eines Hohlraums in einem Halbleitersubstrat ist in der nicht vorveröffentlichten DE 10 2004 04 3357 A1 beschrieben. Dabei wird an der Oberfläche eines Halbleitersubstrats eine gitterartige Struktur aus nicht porös geätztem Substratmaterial erzeugt. Zwischen der gitterartigen Struktur wird ein porösizierter Bereich in die Tiefe des Halbleitersubstrats erzeugt. Durch eine nachfolgende Temperaturbehandlung wird der porösifizierte Bereich durch eine Umlagerung des Halbleitermaterials zur Kaverne umgewandelt. Gleichzeitig kann die Temperaturbehandlung auch dazu genutzt werden, die gitterartige Struktur zu einer Membran oberhalb der Kaverne umzuformen.

Aus der nicht vorveröffentlichten Schrift DE 10 2004 03 6032 A1 ist die Herstellung einer Membran mittels einer Epitaxieschicht auf Stabilisierungselementen über einer Kaverne bekannt. Dabei wird aus dem Halbleitermaterial zur Bildung der Stabilisierungselemente selektiv Material herausgelöst, wodurch poröses Silizium in dem die spätere Kaverne aufweisenden porösen Bereich gebildet wird.

Der Aufbau eines kapazitiven mikromechanischen Sensorelements mittels verschiedener Epitaxieschichten ist aus der Offenlegungsschrift DE 44 10 631 A1 und der nicht vorveröffentlichten Schrift DE 10 2004 06 1796 A1 bekannt.

### Vorteile der Erfindung

Mit der vorliegenden Erfindung wird ein Verfahren zur Herstellung eines mikromechanischen kapazitiven Druckwandlers bzw. ein mit diesem Verfahren hergestelltes mikromechanisches Bauelement beschrieben. Das mikromechanische kapazitive Bauelement in Form eines Druckwandlers wird dabei mittels oberflächenmikromechanischer Prozessschritte hergestellt. Zunächst wird dabei eine erste Elektrode in einem Halbleitersubstrat erzeugt, wobei insbesondere vorgesehen ist, dass das Halbleitersubstrat wenigstens stellenweise dotiert ist. In einem weiteren Verfahrensschritt wird eine Membran mit einer zweiten Elektrode an der Oberfläche des Halbleitersubstrats erzeugt. Dabei kann vorgesehen sein, dass die zweite Elektrode als Teil des Halbleitersubstrats an dessen Oberfläche liegt oder auf die Oberfläche des Halbleitersubstrats aufgebracht wird. Optional wird nach dem Aufbringen in der Epitaxieschicht eine Topologie erzeugt. Weiterhin ist vorgesehen, dass eine erste Schicht, die vorzugsweise aus dielektrischem Material besteht, auf die Membran und das Halbleitersubstrat aufgebracht wird. Mittels dieser ersten Schicht werden die Membran und das Halbleitersubstrat des fertigen mikromechanischen kapazitiven Druckwandlers direkt oder indirekt miteinander mechanisch verbunden. Weiterhin wird zwischen der ersten und der zweiten Elektrode eine vergrabene Kaverne in dem Halbleitersubstrat erzeugt. Mit einem nachfolgenden Ätzschritt durch Öffnungen in der ersten Schicht wird abschließend die Membran aus dem Halbleitersubstrat herausgelöst, wobei die mechanische Verbindung von der Membran zum Halbleitersubstrat wenigstens mittels einer ersten Schicht erfolgt. Diese mechanische Verbindung erlaubt der Membran bzw. der zweiten Elektrode eine bewegliche Aufhängung oberhalb der ersten Elektrode.

Durch die Verwendung von oberflächenmikromechanischen Verfahrensschritten zur Erzeugung des kapazitiven Druckwandlers kann die Herstellung deutlich kostengünstiger realisiert werden, da nur eine Oberfläche bearbeitet werden muss. Somit sind keine aufwendigen mehrmals nacheinander durchzuführende Epitaxieschritte mit nachfolgenden Strukturierungen notwendig. Mittels des vorgeschlagenen Verfahrens können somit kapazitive Sensorelement mit kleinen lateralen und gegenüber dem Substrat vertikalen Abmessungen hergestellt werden. Durch die so hergestellte mikromechanische Sensorstruktur kann das kapazitive Sensorelement mit einer geringen Leistungsaufnahme betrieben werden. Dabei ist besonders vorteilhaft, dass bereits bekannte Standardprozesse der Oberflächenmikromechanik (OMM) zur Herstellung verwendet werden können. Durch einen monolithischen Aufbau kann die verwendete Mikromechanik zusammen mit der Mikroelektronik auf einem Chip integriert werden. Vorteilhaft ist insbesondere, dass die beiden Elektroden elektrisch völlig voneinander isoliert, so dass keine Leckströme fließen. Parasitäre Kapazitäten verursacht durch pn-Übergänge entfallen.

In einer Ausgestaltung der Erfmdung wird die Kaverne durch einen isotropen Ätzvorgang oder mittels einer Porösifizierung des Halbleitermaterials in einem Opferbereich des Halbleitersubstrats mit nachfolgender thermischer Umlagerung oder Herauslösung des porösifizierten Halbleitermaterials erzeugt.

Bei der Verwendung von porösem Silizium zur Erzeugung der Kaverne kann vorgesehen sein, dass ausgehend von der Oberfläche des Halbleitersubstrats im Opferbereich gitterartige Strukturen an der Oberfläche des Halbleitersubstrats bei der Porösifizierung ausgespart werden. Die zweite Elektrode zur Bildung des kapazitiven Druckwandlers wird dabei durch eine nachfolgende thermische Umlagerung der nicht porös geätzten, gitterartigen Struktur des Halbleitermaterials erzeugt, vorzugsweise während der Bildung der Kaverne. Alternativ dazu kann die zweite Elektrode auch durch das Aufbringen einer leitfähigen Schicht auf die gitterartige Struktur erzeugt werden.

Zur Verstärkung der Membran kann auf die Oberfläche des Halbleitersubstrats bzw. auf die zweite Elektrode eine Epitaxieschicht aufgebracht werden, die durch die erste Schicht abgedeckt wird. Besonders vorteilhaft ist dabei, wenn die erste Schicht ein dielektrisches Material aufweist. Vor dem Aufbringen der Epitaxieschicht kann am Rand der Kaverne bzw. Membran optional eine Topologie in der Epitaxieschicht z. B. mit einem LOCOS-Prozess oder einem LOCOS-Prozess mit nachfolgendem Entfernen der LOCOS-Schicht erzeugt werden. Diese Topologie kann zum Einstellen der Empfindlichkeit des Drucksensors durch die Steifigkeit des Membranrandes verwendet werden.

Vorteilhafterweise werden in der ersten Schicht im seitlichen Bereich der Membran Opferschichtätzlöcher erzeugt. Diese Opferschichtätzlöcher stellen den Zugang dar, um die zweite Elektrode mittels des Ätzprozesses vom Halbleitersubstrat zu separieren. In einer besonderen Weiterbildung der Erfindung kann durch den Ätzprozess auch eine Trennung der aufgebrachten Epitaxieschicht vorgenommen werden. Dabei kann die Epitaxieschicht über der Kaverne von der Epitaxieschicht oberhalb des die Kaverne umgebenden Halbleitersubstrats getrennt werden. Somit ist eine (lokale) Verdickung der Membran durch die Epitaxieschicht möglich.

Vorteilhafterweise ist vorgesehen, auf die erste Schicht oberhalb des Randbereichs der Membran eine zweite insbesondere strukturierte Schicht aufzubringen, um die mechanische Verbindung zwischen Membran und Halbleitersubstrat zu stärken. Wird die zweite Schicht, die beispielsweise aus Polysilizium bestehen kann, vor dem Ätzprozess zur Bildung der Membran aufgebracht, sind sowohl in der ersten als auch in der zweiten Schicht Opferschichtätzlöcher vorgesehen, um das Material zur Trennung der Membran vom Halbleitersubstrat herauszulösen.

In einer besonderen Ausgestaltung der Erfindung ist vorgesehen, dass die zweite Schicht in Form einer federartigen Aufhängung der Membran strukturiert wird. Diese federartige Aufhängung ist dabei besonders im Randbereich der Membran vorgesehen. In speziellen Ausgestaltungen kann die federartige Aufhängung den gesamten Randbereich der Membran umfassen. Vorteilhaft ist, wenn die zweite Schicht derart strukturiert wird, dass mehrere, nicht miteinander verbundene und räumlich begrenzte Elemente erzeugt werden.

Nach dem Ätzprozess zur Trennung der Membran vom Halbleitersubstrat ist vorgesehen, die Opferschichtätzlöcher zu verschließen. Dies kann beispielsweise durch eine Oxidation oder durch ein Verschließen mit Verfüllungsmaterial erreicht werden.

Die Erfindung kann vorteilhaft für Drucksensoren, Mikrofone, Beschleunigungssensoren in z-Richtung und andere Sensoren eingesetzt werden, bei denen eine elektrische oder weitgehend thermische Isolation der (monokristallinen) Membran erwünscht ist und/oder die mit einem kapazitiven Wandlerprinzip arbeiten. Zur Realisierung von Differenzdrucksensoren bzw. Mikrofonen kann vorgesehen sein, die Kaverne von der Rückseite des Halbleitersubstrats zu öffnen. Vorteilhafterweise geschieht das durch einen Trench-Prozess.

Weitere Vorteile ergeben sich aus der nachfolgenden Beschreibung bzw. aus den abhängigen Patentansprüchen.

### Zeichnungen

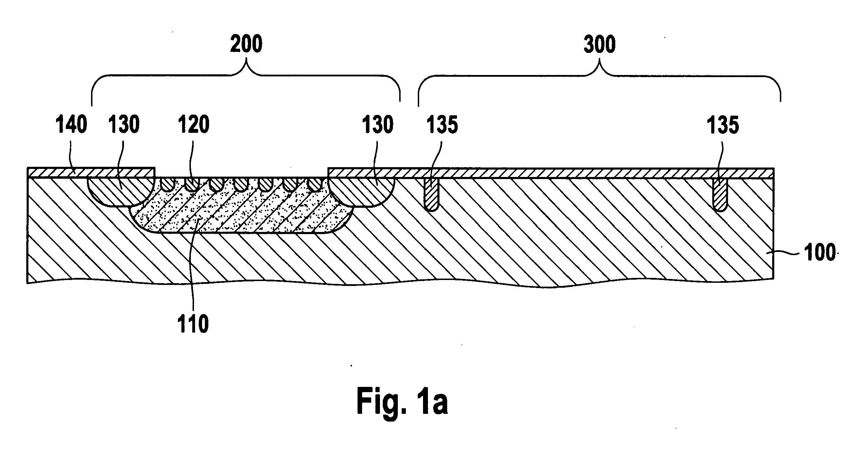

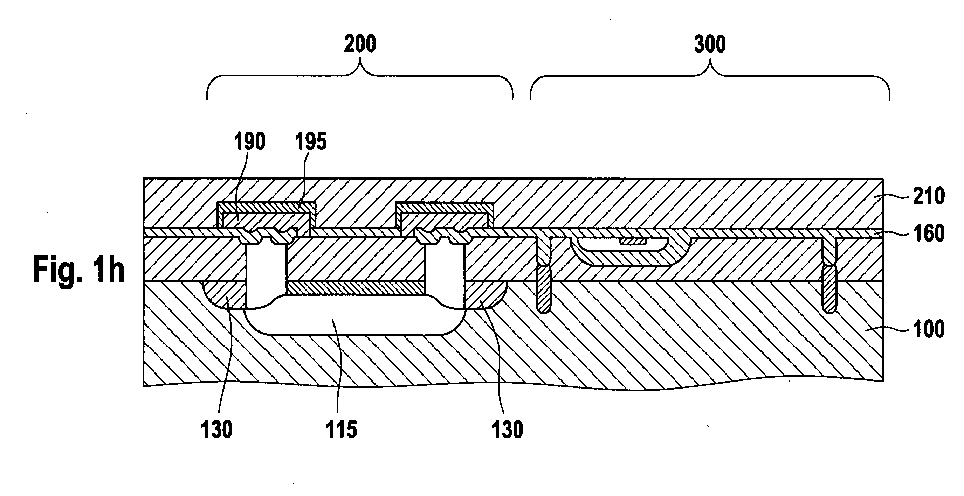

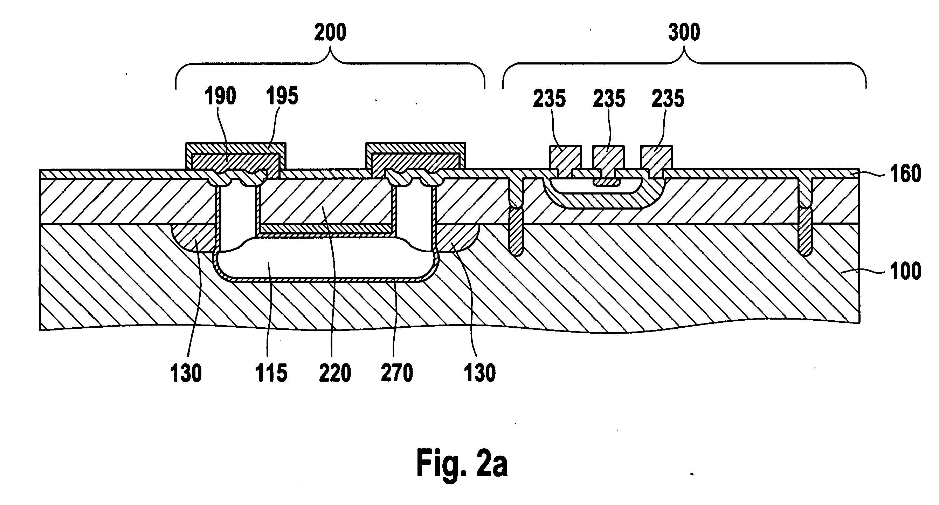

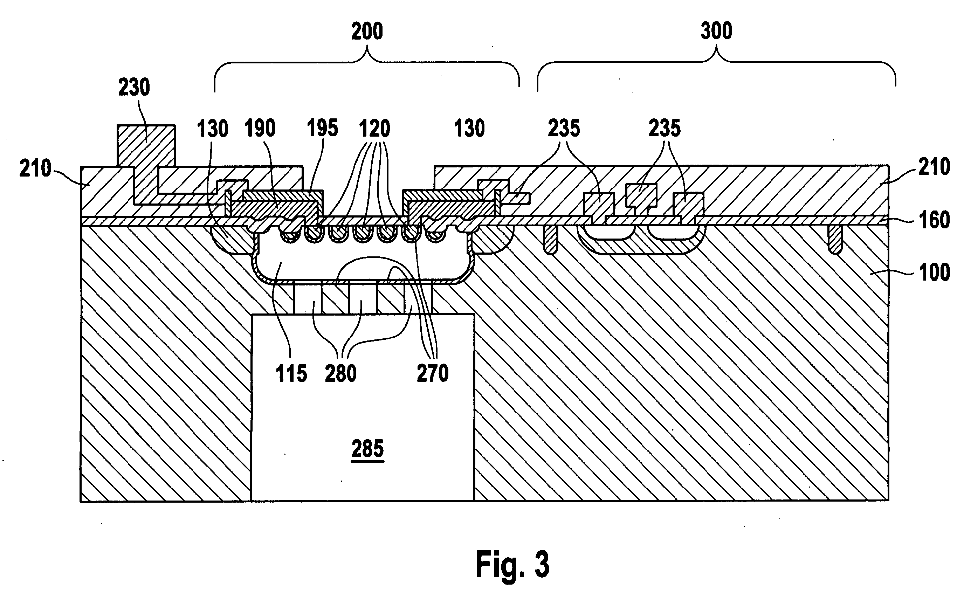

In den Figuren 1a bis 1j wird das erfindungsgemäße Herstellungsverfahren schematisch dargestellt. In den Figuren 2a bis 2c ist der Herstellungsprozess für einen Relativdrucksensor dargestellt. Figur 3 zeigt eine weitere mögliche Herstellung eines Mikrofons mit dem erfindungsgemäßen Herstellungsprozess

### Ausführungsbeispiele

Für die kapazitive Druckmessung werden voneinander beabstandete und gegeneinander elektrisch isoliert Elektroden benötigt, die separat elektrisch angesteuert werden sollten. Gemäß der vorliegenden Erfindung werden diese elektrisch isolierten Elektroden aus einem Halbleitersubstrat herausgearbeitet. Die erste Elektrode kann dabei durch die Verwendung eines dotierten Halbleitersubstrats selbst gebildet werden. In einem weiteren Ausführungsbeispiel ist jedoch auch möglich, die erste Elektrode im Halbleitersubstrat durch die Dotierung des Halbleitersubstrats in einem räumlich begrenzten Bereich zu erzeugen. Die zweite Elektrode, die ebenfalls aus dem Halbleitermaterial bestehen kann und aus dem Halbleitersubstrat und ggfs. der Epitaxieschicht herausgearbeitet wird, kann erfindungsgemäß über einer Kaverne mittels einer dielektrischen Schicht flexibel am Substrat aufgehängt werden. Optional kann auch vorgesehen sein, die flexible zweite Elektrode über federartige Aufhängungen bzw. Verstärkungen am Substrat zu verankern. Die zweite Elektrode stellt alleine bzw. mit weiteren auf das Halbleitersubstrat abgeschiedenen Schichten die Messmembran dar, die in Abhängigkeit eines auf sie wirkenden Drucks lageabhängig ein elektrisches Signal erzeugt. Durch die Verwendung der Membran als träge Masse kann das so hergestellte mikromechanische Bauelement auch als Beschleunigungssensor in Z-Richtung verwendet werden.

Ausgehend von einem p-dotierten Halbleitersubstrat 100 wird, wie in Figur 1a dargestellt, erfindungsgemäß ein Drucksensorbereich 200 ausgehend von der Oberfläche des Halbleitersubstrats 100 erzeugt. Optional kann neben dem erzeugten Drucksensorbereich 200 ein Schaltungsbereich 300 erzeugt werden. Bei der Herstellung dieses Schaltungsbereichs 300 können Prozessschritte, beispielsweise im Rahmen von oberflächenmikromechanischen Verfahrensschritte, die zur Erzeugung des Drucksensorbereichs 200 verwendet werden, gleichzeitig angewandt werden. Zur Erzeugung der Kaverne 115 wird in einem ersten Bereich 110 des Halbleitersubstrats 100 poröses Silizium erzeugt, beispielsweise durch ein selektives Herauslösen des Halbleitermaterials. Nachfolgend wird aus dem porösen Silizium im ersten Bereich 110 die Kaverne 115 beispielsweise durch einen thermischen Umlagerungsschritt erzeugt. Da die Herstellung des porösen Siliziums nicht Gegenstand der vorliegenden Erfindung ist, sei explizit auf die Schrift DE 100 32 579 A1 verwiesen, in dem das bevorzugte Herstellungsverfahren für poröses Siliziums beschrieben wird. Wie in Figur 1a dargestellt, werden in dem Bereich 110 Stege bzw. gitterartige Strukturen 120 ausgespart, die durch einen selektiven Ätzprozess oder durch spezielle Maskierungstechniken nicht porös geätzt werden. Diese gitterartigen Strukturen 120 bilden in dem nachfolgenden thermischen Umlagerungsschritt die zweite Elektrode 125. Weiterhin werden am Rand des Bereichs 110 bzw. der späteren Kaverne 115 durch eine Umdotierung n-dotierte Bereiche 130 erzeugt. Durch diese Umdotierung wird eine laterale Begrenzung des bei der Herstellung des porösen Siliziumbereichs 110 erforderlichen elektrochemischen Ätzprozesses ermöglicht. Gleichzeitig dienen die n-dotierten Bereiche als Kavernenbegrenzung. Die Umdotierung der vorzugsweise rund um die Kaverne verlaufenden Bereiche 130 sowie die Erzeugung von Anschlussbereichen 135 für den Schaltungsbereich 300 können dabei beispielsweise mittels Verfahren zur Implantation und/oder Diffusion erzeugt werden. Die Erzeugung des porösen Bereichs 110 wird vorteilhafterweise mit einer Ätzmaske 140 beispielsweise aus Siliziumdioxid und/oder Siliziumnitrid erzeugt. Zur konkreten Erzeugung der gitterartigen Strukturen sei auf die nicht vorveröffentlichten Schriften DE 10 2004 03 6035 A1 und DE 10 2004 04 3357 A1 verwiesen.

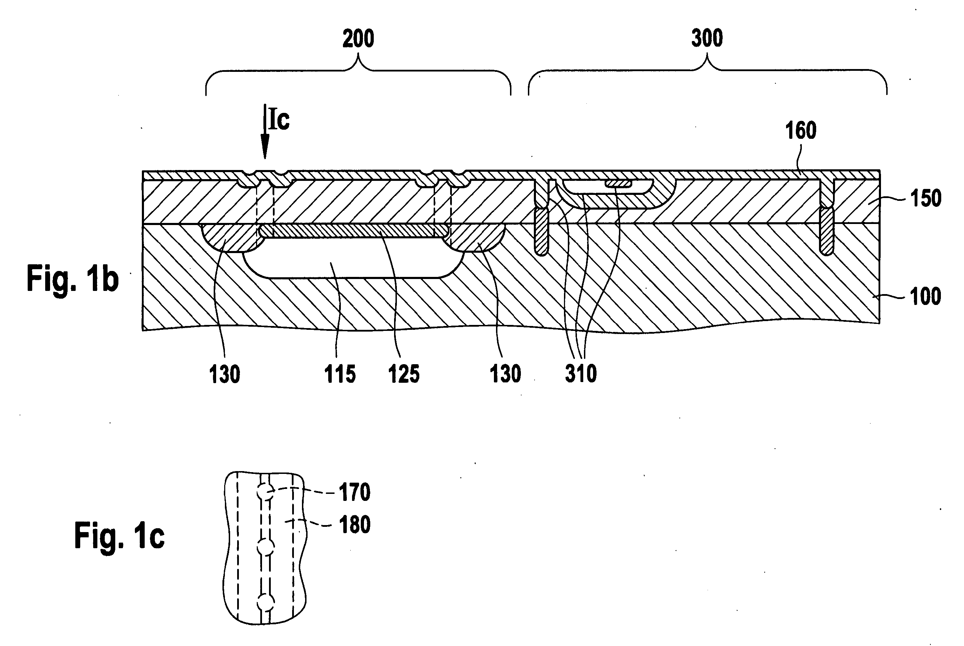

Nach der Entfernung der Ätzmaske 140 wird, wie in Figur 1b dargestellt, auf das Halbleitersubstrat und die durch die thermische Umlagerung entstandene zweite Elektrode 125 eine Epitaxieschicht 150 aufgebracht. Im Randbereich 180 der Kaverne bzw. der Membran kann optional eine Topologie erzeugt werden, z. B. über einen LOCOS-Prozess mit nachfolgender Entfernung des LOCOS-Oxids. Auf die Epitaxieschicht 150 werden anschließend eine oder mehrere dielektrische Shichten 160 aufgebracht, beispielsweise aus Silziumdioxid oder Siliziumnitrid. Außerdem werden Opferschichtätzlöcher 170 im Randbereich 180 der Kaverne bzw. der Membran eingebracht (siehe auch die vergrößerte Aufsicht in Figur 1c), um in einem späteren Verfahrensschritt u.a. die Membran 125 von dem Halbleitersubstrat 100 bzw. den Bereichen 130 zu trennen. Zur Erzeugung einer geschlossenen Membran werden die Opferschichtätzlöcher durch anschließendes Abscheiden einer Verschlussschicht wieder verschlossen. Wie bereits erwähnt, können parallel zur Prozessierung des Drucksensorbereichs 200 im Schaltungsbereich 300 Elemente 310 zur Realisierung einer integrierten Schaltung erzeugt werden, die für die spätere Ansteuerung bzw. Auswertung des kapazitiven Drucksensors vorgesehen sein können.

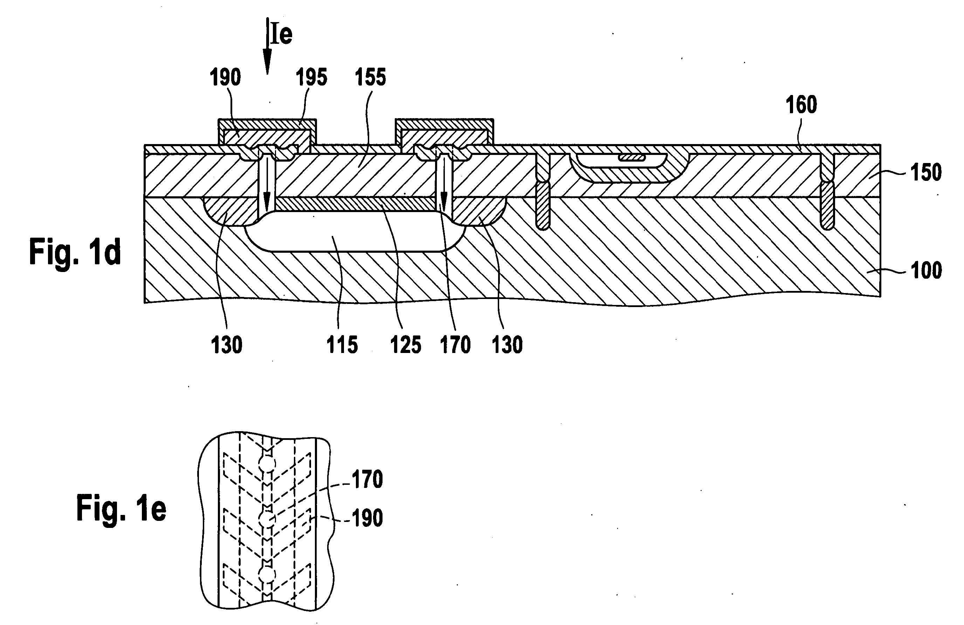

In Figur 1d und Figur 1e sind optionale Ausgestaltungen des erfindungsgemäßen Herstellungsverfahrens bzw. des mit dem Verfahren hergestellten mikromechanischen Bauelementes aufgezeigt. Dabei werden federartige Aufhängungen 190 derart über den Rand der Membran bzw. Kaverne 115 erzeugt, dass die mechanische Aufhängung der Membran über die dielektrische Schicht 160 unterstützt wird. Vorzugsweise wird zunächst eine zweite Schicht auf die erste dielektrische Schicht 160 aufgebracht, um anschließend in die federartigen Aufhängungen 190 strukturiert zu werden. Wie aus Figur 1e zu erkennen ist, sind die federartigen Aufhängungen 190 als separate, voneinander getrennte, räumlich auf einen Bereich oberhalb des Randbereichs der Kaverne begrenzte Elemente ausgestaltet. Diese federartigen Aufhängungen 190 dienen zur Stabilisierung der mechanischen Aufhängung der Membran. Vorzugsweise werden diese federartigen Aufhängungen 190 aus Polysilizium gebildet. Um die federartigen Aufhängungen 190 zu schützen, wird das Polysilizium mit einer Passivierungsschicht 195 bedeckt. Werden federartige Aufhängungen 190 zur mechanischen Aufhängung der Membran bzw. der Elektrode 125 verwendet, ist bevorzugt vorgesehen, dass die Elemente 190 vor der Trennung der zweiten Elektrode 125 vom Bereich 130 erzeugt werden, um die mechanische Stabilität der Membran, bestehend aus der Epitaxieschicht 155 und der zweiten Elektrode 125 sicherzustellen.

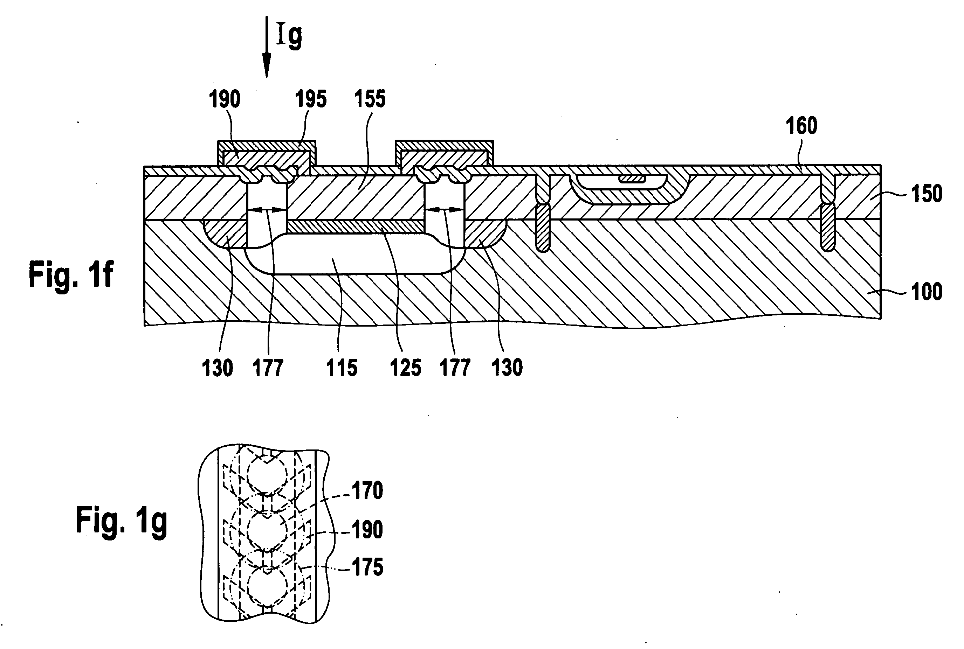

Ausgehend von den Opferschichtätzlöchern 170 erfolgt ein Unterätzen der Epitaxieschicht 150 sowie der zweiten Elektrode 125 und der Bereiche 130, wie in Figur 1f dargestellt. Durch diese Unterätzung wird die Elektrode 125 vom Randbereich 130 getrennt. Der Ätzprozess wird dabei solange durchgeführt, bis die Membranelektrode lediglich über die dielektrische Schicht 160 und ggf. die federartigen Aufhängungen 190 gehalten werden. Das Unterätzen erfolgt vorteilhafterweise mittels eines Gasphasenätzens, beispielsweise mit ClF₃ oder SF₆, wobei Ätzfronten 175 erzeugt werden, wie in Figur 1g dargestellt. Durch dieses Unterätzen verbreitert sich der Abstand 177 der Membranelektrode, bestehend aus der Elektrode 125 und der Epitaxieschicht 155, von dem sie umgebenden Halbleitersubstrat, bestehend aus dem Halbleitersubstrat 100 sowie der Epitaxieschicht 150.

Das Opferschichtätzen des Substratmaterials bzw. des Epitaxiematerials kann sowohl einstufig mit einem isotropen Ätzverfahren als auch wie dargestellt zweistufig zunächst anisotrop und nach Durchätzen der Membran isotrop erfolgen.

Um ein abgeschlossenes Volumen in der Kaverne zu erzeugen, wird nach erfolgter Unterätzung wenigstens eine passivierende Schicht 210 abgeschieden, die die Opferschichtätzlöcher 170 verschließt und eine planarisierte Oberfläche des Sensorelements erzeugt. Alternativ können die Opferschichtätzlöcher auch mittels einer Oxidation des Halbleitermaterials der Löcher verschlossen werden.

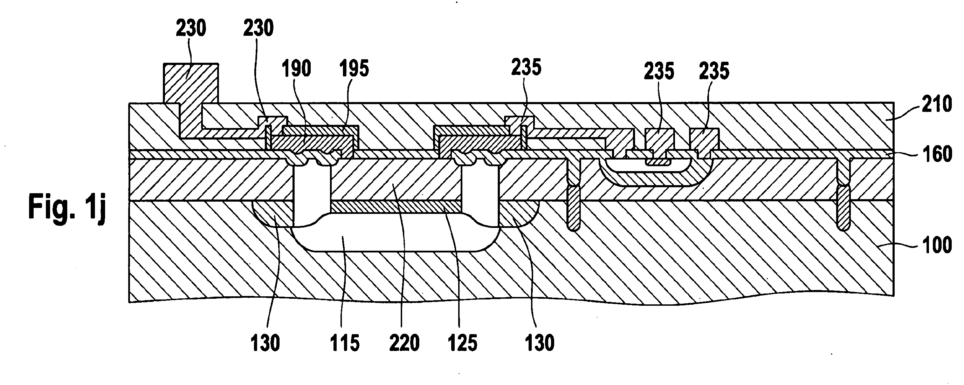

Im abschließenden Backend-Schaltungsprozess, wie er in Figur 1j dargestellt ist, werden Metallisierungen 230 und 235 zur Kontaktierung der Membranelektrode 220 erzeugt. Durch die Verwendung von Polysilizium als Material für die federartigen Aufhängungen 190 sowie die Verwendung von leitfähigem Epitaxiematerial für die Schicht 150 ermöglichen eine Kontaktierung der zweiten Elektrode 125. Die erste Elektrode kann hingegen durch spezielle Elemente 135 kontaktiert werden, die gleichzeitig für die Schaltungselemente im Schaltungsbereich 300 genutzt werden können. Allgemein können parallel zu den Kontaktierungen im Sensorbereich 200 auch Kontaktierungen 235 der Schaltungselemente im Schaltungsbereich 300 vorgenommen werden. Diese Kontaktierungen können an die Oberfläche des so hergestellten Halbleitersubstrats geführt werden. Alternativ kann auch vorgesehen sein, die Kontaktierungen vergraben unter der Schicht 210 weiterzuführen.

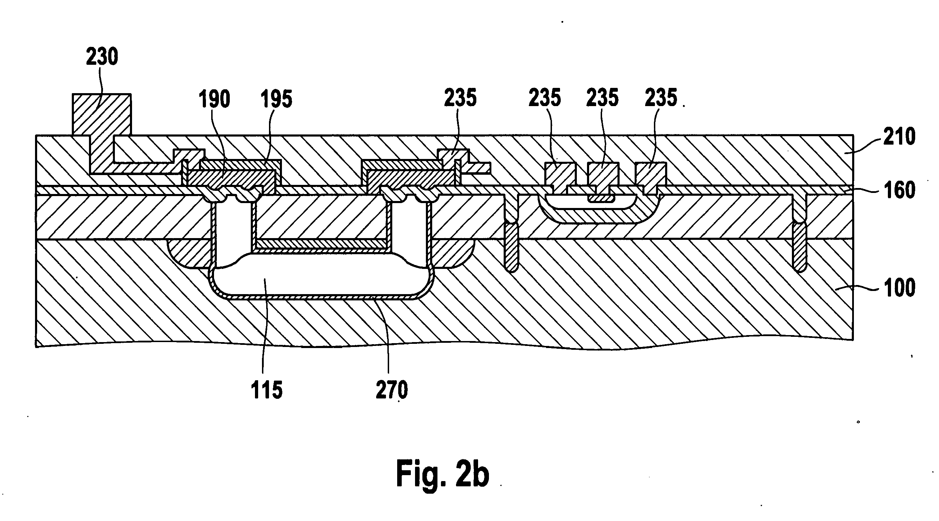

Um mit dem erfindungsgemäßen Verfahren einen Relativdrucksensor herzustellen, ist es nötig, die Kaverne 115 von der Rückseite des Halbleitersubstrats 100 zu öffnen. Zu diesem Zweck werden zunächst Verfahrensschritte entsprechend der Figuren 1a bis 1g verwendet, bevor im Anschluss Verfahrensschritte gemäß den Figuren 2a bis 2c durchgeführt werden. Nach dem Unterätzen der Opferschichtätzlöcher 170 wird eine Oxidationsschicht 270 auf der Innenseite der Kaverne erzeugt. Alternativ kann auch eine dielektrische Schicht 270 auf die Innenseite der Kaverne abgeschieden werden. Entsprechend dem Metallisierungsschritt der Figur 1j wird im vorliegenden Ausführungsbeispiel eine Kontaktierung der Membranelektrode 125 sowie der Schaltungselemente im Schaltungsbereich vorgenommen (siehe Figur 2b in Verbindung mit Figur 1j). Abschließend wird, wie bereits zum Verfahrensschritt zur Figur 1j beschrieben, eine Passivierungsschicht 210 aufgebracht.

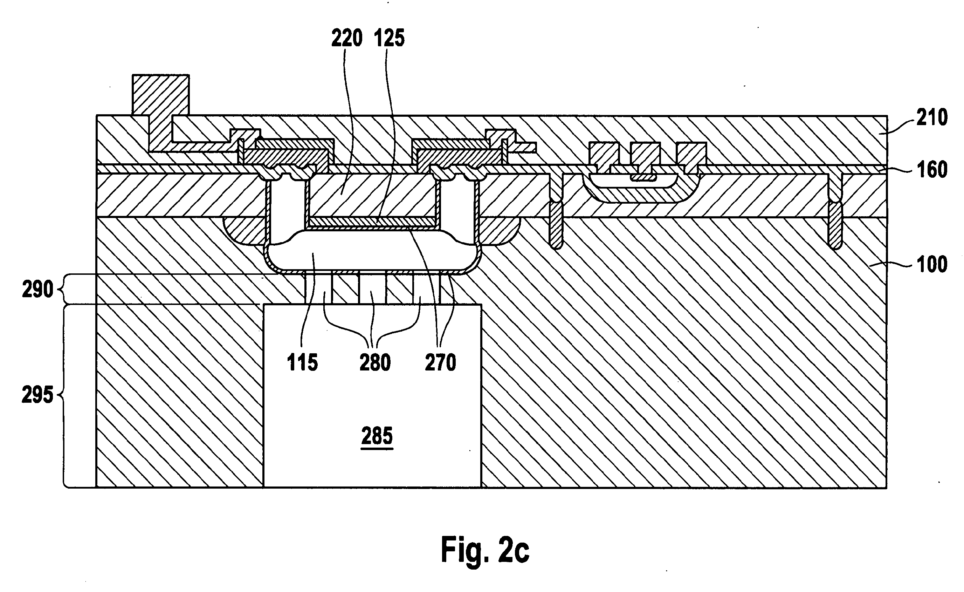

Um eine Öffnung der Kaverne 115 zu erreichen, wird im vorliegenden Ausführungsbeispiel ein zweistufiger Trench-Ätzschritt von der Rückseite des Halbleitersubstrats 100 durchgeführt. Dabei wird in einem ersten Tieftrenchschritt 295 eine Öffnung 285 erzeugt. Anschließend werden mit einem Flachtrenchätzprozess 290 Lüftungslöcher 280 von der rückwärtigen Seite der Kaverne 115 eingebracht. Dabei kann beispielsweise ein gerichtetes Oxidätzen von der Rückseite zur Entfernung der Oxidschicht 270 über den Lüftungslöchern 280 verwendet werden (siehe Figur 2c). Durch die Anzahl und Form der Lüftungslöcher 280 kann die erste Elektrode, die im Bereich der Öffnung 285 gegenüber der zweiten Elektrode 125 erzeugt wird, entsprechend gestaltet werden.

In Figur 3 ist ein weiteres Ausführungsbeispiel zur Realisierung eines kapazitiven Mikrofons, eines Differenzdrucksensors bzw. eines z-Beschleunigungssensors dargestellt. Wie bereits anhand der Figur 2c beschrieben, werden mittels verschiedener Trenchätzschritte von der Rückseite des Halbleitersubstrats 100 Öffnungen in die Kaverne 115 erzeugt. Zur Einstellung der Empfindlichkeit des kapazitiven Druckwandlers wird die Membranschicht, bestehend aus der zweiten Elektrode 125 bzw. 120 und der Epitaxieschicht 155, nachträglich rückgedünnt, beispielsweise durch einen weiteren Ätzvorgang. Alternativ kann auch vorgesehen sein, dass die gitterartigen Strukturen 120 nicht thermisch zu einer Membranschicht 125 umgelagert werden, wie es in Figur 3 dargestellt ist. Dadurch kann erreicht werden, dass die gitterartigen Strukturen 120 selbst als zweite Elektrode verwendet werden können. Optional kann auch vorgesehen sein, dass die gitterartigen Strukturen 120 nur als Grundgerüst für die zweite Elektrode bestehend aus der Schicht 195 oberhalb der ersten Elektrode dienen.

Vorteilhafterweise wird als Substrat ein monokristallines Siliziumsubstrat verwendet. Wird der thermische Umlagerungsprozess zur Bildung der zweiten Elektrode 125 entsprechend gesteuert, kann ebenfalls erreicht werden, dass sich die zweite Elektrode ebenfalls als monokristallines Silizium ausbildet.

## Patentansprüche

1. Verfahren zur Herstellung eines mikromechanischen kapazitiven Druckwandlers,
wobei die Herstellung die oberflächenmikromechanischen Verfahrensschritte
- Erzeugen einer ersten Elektrode innerhalb eines insbesondere dotierten Silizium-Halbleitersubstrats (100) und
- Erzeugen einer einkristallinen gitterartigen Struktur zur Bildung einer zweiten Elektrode (120, 125) oberhalb eines porös geätzten ersten Bereichs (110) in dem Silizium-Halbleitersubstrat, und
- Aufbringen einer Epitaxieschicht (150) auf das Silizium-Halbleitersubstrat (100) und die zweite Elektrode (120, 125), und
- Aufbringen einer ersten Schicht (160) auf die Epitaxieschicht (150) und
- Erzeugen einer vergrabenen Kaverne (115) mittels des ersten Bereichs (110) zwischen der ersten und der zweiten Elektrode und
- Bilden einer Membran (220) auf der zweiten Elektrode (120, 125) oberhalb des ersten porösen Bereichs (110) durch trennen der Epitaxieschicht (155) auf der zweiten Elektrode von der Epitaxieschicht (150) auf dem Halbleitersubstrats mittels eines Ätzprozesses, wobei vorgesehen ist, dass durch die Trennung eine flexible mechanische Verbindung zwischen Membran und Halbleitersubstrat mittels der ersten Schicht (160) entsteht.

2. Verfahren zur Herstellung eines mikromechanischen kapazitiven Druckwandlers nach Anspruch 1, **dadurch gekennzeichnet, dass** die Kontaktierung der zweiten Elektrode durch die Verwendung von leitfähigem Epitaxiematerial der Epitaxieschicht (155) erfolgt.

3. Verfahren nach Anspruch 1, **dadurch gekennzeichnet, dass** als Ätzprozess ein Gasphasenätzen vorgesehen ist, insbesondere durch ClF₃ oder SF₆.

4. Verfahren nach Anspruch 1, **dadurch gekennzeichnet, dass** die Epitaxieschicht im Randbereich der Kaverne eine Topologie aufweist, wobei insbesondere vorgesehen ist, dass die auf die Epitaxieschicht aufgebrachte erste Schicht ebenfalls eine Topologie im Randbereich der Kaverne aufweist.

5. Verfahren zur Herstellung eines mikromechanischen kapazitiven Druckwandlers nach Anspruch 1, **dadurch gekennzeichnet, dass** die Kaverne (115) durch
- einen isotropen Ätzvorgang oder
- eine
- thermischer Umlagerung oder
- Herauslösung des porösifizierten Silizium-Halbleitermaterials im ersten Bereich (110) erzeugt wird.

6. Verfahren zur Herstellung eines mikromechanischen kapazitiven Druckwandlers nach Anspruch 5, **dadurch gekennzeichnet, dass** die zweite Elektrode (120, 125) durch
- die thermische Umlagerung der nicht porös geätzten gitterartigen Struktur des Halbleitermaterials oder
- eine Erzeugung einer leitfähigen Schicht auf der gitterartigen Struktur erzeugt wird.

7. Verfahren zur Herstellung eines mikromechanischen kapazitiven Druckwandlers nach Anspruch 1 oder 5, **dadurch gekennzeichnet, dass** in der ersten Schicht (160) im seitlichen Bereich der Membran Opferschichtätzlöcher (170) erzeugt werden, durch die die Membran bzw. die zweite Elektrode wenigstens mittels eines Ätzprozesses vom Halbleitersubstrat separiert wird, wobei insbesondere vorgesehen ist, dass der Ätzprozess zusätzlich die Epitaxieschicht oberhalb der Kaverne von der Epitaxieschicht oberhalb des Halbleitersubstrats separiert.

8. Verfahren zur Herstellung eines mikromechanischen kapazitiven Druckwandlers nach Anspruch 1, **dadurch gekennzeichnet, dass** auf die erste Schicht oberhalb des Randbereichs der Membran eine zweite Schicht (190), insbesondere aus Polysilizium, aufgebracht wird, wobei vorgesehen ist, dass
- die zweite Schicht in Form einer federartigen Aufhängung (190) der Membran (220) in wenigstens einem Teil des Randbereichs der Membran strukturiert wird, wobei insbesondere vorgesehen ist, dass die zweite Schicht in mehrere, nicht miteinander verbundene und räumlich begrenzte Elemente strukturiert wird, die mittels der so erzeugten federartigen Aufhängung die Membran bzw. die zweite Elektrode oberhalb der Kaverne beweglich lagern und
- in der ersten und zweiten Schicht Opferschichtätzlöcher für den Ätzprozess vorgesehen sind, wobei insbesondere vorgesehen ist, dass die Opferschichtätzlöcher (170) nach dem Ätzprozess durch eine Oxidation und/oder durch ein Einbringen von Verfüllungsmaterial verschlossen werden

9. Verfahren nach Anspruch 7 oder 8, **dadurch gekennzeichnet, dass** die Kaverne von der Rückseite des Halbleitersubstrats geöffnet wird, insbesondere durch einen Trenchprozess.

10. Verfahren zur Herstellung eines mikromechanischen kapazitiven Druckwandlers nach Anspruch 8, **dadurch gekennzeichnet, dass** die Kontaktierung der zweiten Elektrode über die federartige Aufhängung (190) erfolgt, wobei insbesondere vorgesehen ist, dass die federartige Aufhängung Polysilizium aufweist.

11. Mikromechanisches Bauelement, herstellbar nach einem der Ansprüche 1 bis 10, mit
- einer ersten Elektrode innerhalb eines insbesondere dotierten Silizium-Halbleitersubstrats (100), und
- einer eine Epitaxieschicht (155) und eine zweite Elektrode (120, 125) aufweisende Membran (220) und
- einer ersten Schicht (160) auf der Membran und dem Halbleitersubstrat und
- einer zwischen der ersten und der zweiten Elektrode vergrabenen Kaverne (115),
wobei die Membran oberhalb der ersten Elektrode mittels der ersten Schicht beweglich gehalten wird und die zweite Elektrode (155) lateral vom Halbleitersubstrat (150) beabstandet ist.

12. Mikromechanisches Bauelement nach Anspruch 11, **dadurch gekennzeichnet, dass**
die Kontaktierung der zweiten Elektrode durch die leitfähige Epitaxieschicht (155) erfolgt.

13. Mikromechanisches Bauelement nach Anspruch 12, **dadurch gekennzeichnet, dass** sich auf der ersten Schicht oberhalb des Randbereichs der Membran eine zweite Schicht (190), insbesondere aus Polysilizium, befindet, die in Form einer federartigen Aufhängung der Membran in wenigstens einem Teil des Randbereichs der Membran ausgestaltet ist, wobei insbesondere vorgesehen ist, dass die zweite Schicht in mehrere, nicht miteinander verbundene und räumlich begrenzte Elemente strukturiert ist, die gemeinsam die federartige Aufhängung der Membran bzw. der zweiten Elektrode bilden und/oder eine elektrische Kontaktierung der zweiten Elektrode ermöglicht.

14. Verfahren nach Anspruch 13, **dadurch gekennzeichnet, dass** die erste Schicht eine Topologie im Randbereich der Kaverne aufweist.

15. Mikromechanisches Bauelement nach Anspruch 13, **dadurch gekennzeichnet, dass** die erste und/oder die zweite Schicht Opferschichtätzlöcher (170) aufweisen, wobei die Opferschichtätzlöcher durch ein Oxid oder ein Verfüllungsmaterial verschlossen sind.

16. Mikromechanisches Bauelement nach einem der Ansprüche 12 bis 15, **dadurch gekennzeichnet, dass** das Bauelement als Absolutdrucksensor, oder Relativdrucksensor, oder Mikrofon oder Beschleunigungssensor verwendbar ist, wobei insbesondere vorgesehen ist, dass der Relativdrucksensor bzw. das Mikrofon eine von der Rückseite des Halbleitersubstrats eingebrachte Kaverne aufweist und/oder die erste Elektrode wenigstens ein Durchgangsloch aufweist.

17. Mikromechanisches Bauelement nach Anspruch 11, **dadurch gekennzeichnet, dass** die vergrabene Kaverne wenigstens teilweise von einem Randbereich (130) umgeben ist, wobei vorgesehen ist, dass die Dotierung des Randbereichs und die Dotierung der ersten und zweiten Elektrode unterschiedlich sind.

## Claims

1. Method for producing a micromechanical capacitive pressure transducer,
the production comprising the surface-micromechanical method steps of
- producing a first electrode within a, particularly doped, silicon semiconductor substrate (100) and
- producing a monocrystalline lattice-like structure for forming a second electrode (120, 125) above a porously etched first region (110) in the silicon semiconductor substrate, and
- applying an epitaxial layer (150) to the silicon semiconductor substrate (100) and the second electrode (120, 125), and
- applying a first layer (160) to the epitaxial layer (150) and
- producing a buried cavity (115) between the first electrode and the second electrode by means of the first region (110) and
- forming a membrane (220) on the second electrode (120, 125) above the first porous region (110) by separating the epitaxial layer (155) on the second electrode from the epitaxial layer (150) on the semiconductor substrate by means of an etching process, it being provided that the separation creates a flexible mechanical connection between the membrane and the semiconductor substrate by means of the first layer (160).

2. Method for producing a micromechanical capacitive pressure transducer according to Claim 1, **characterized in that** the contacting of the second electrode takes place by using a conductive epitaxial material of the epitaxial layer (155).

3. Method according to Claim 1, **characterized in that** a gas-phase etching, in particular by ClF₃ or SF₆, is provided as the etching process.

4. Method according to Claim 1, **characterized in that** the epitaxial layer has a topology in the edge region of the cavity, it being provided in particular that the first layer, applied to the epitaxial layer, likewise has a topology in the edge region of the cavity.

5. Method for producing a micromechanical capacitive pressure transducer according to Claim 1, **characterized in that** the cavity (115) is produced by
- an isotropic etching process or
- a thermal rearrangement or
- dissolution of the porosified silicon semiconductor material in the first region (110).

6. Method for producing a micromechanical capacitive pressure transducer according to Claim 5, **characterized in that**
the second electrode (120, 125) is produced by
- the thermal rearrangement of the not porously etched lattice-like structure of the semiconductor material or
- production of a conductive layer on the lattice-like structure.

7. Method for producing a micromechanical capacitive pressure transducer according to Claim 1 or 5, **characterized in that** sacrificial-layer etching holes (170) are produced in the first layer (160), in the lateral region of the membrane, through which holes the membrane or the second electrode is separated from the semiconductor substrate at least by an etching process, it being provided in particular that the etching process additionally separates the epitaxial layer above the cavity from the epitaxial layer above the semiconductor substrate.

8. Method for producing a micromechanical capacitive pressure transducer according to Claim 1, **characterized in that** a second layer (190), in particular of polysilicon, is applied to the first layer above the edge region of the membrane, it being provided that
- the second layer is structured in the form of a spring-like suspension (190) of the membrane (220) in at least part of the edge region of the membrane, it being provided in particular that the second layer is structured into multiple elements that are not connected to one another and are spatially restricted, which by means of the spring-like suspension thus produced support the membrane or the second electrode above the cavity in such a way as to allow movement and
- sacrificial-layer etching holes for the etching process are provided in the first and second layers, it being provided in particular that the sacrificial-layer etching holes (170) are closed after the etching process by oxidation and/or introduction of filling material.

9. Method according to Claim 7 or 8, **characterized in that** the cavity is opened from the rear side of the semiconductor substrate, in particular by a trench process.

10. Method for producing a micromechanical capacitive pressure transducer according to Claim 8, **characterized in that** the contacting of the second electrode takes place by way of the spring-like suspension (190), it being provided in particular that the spring-like suspension comprises polysilicon.

11. Micromechanical component that can be produced according to one of Claims 1 to 10, comprising
- a first electrode within a, particularly doped, silicon semiconductor substrate (100), and
- a membrane (220), having an epitaxial layer (155) and a second electrode (120, 125), and
- a first layer (160) on the membrane and the semiconductor substrate and
- a cavity (115) buried between the first and second electrodes,
the membrane being held above the first electrode by means of the first layer in such a way as to allow movement and the second electrode (155) being laterally set apart from the semiconductor substrate (150).

12. Micromechanical component according to Claim 11, **characterized in that**
the contacting of the second electrode takes place through the conductive epitaxial layer (155).

13. Micromechanical component according to Claim 12, **characterized in that** on the first layer there is above the edge region of the membrane a second layer (190), in particular of polysilicon, which is designed in the form of a spring-like suspension of the membrane in at least part of the edge region of the membrane, it being provided in particular that the second layer is structured into multiple elements that are not connected to one another and are spatially restricted, which together form the spring-like suspension of the membrane or the second electrode and/or allow electrical contacting of the second electrode.

14. Method according to Claim 13, **characterized in that** the first layer has a topology in the edge region of the cavity.

15. Micromechanical component according to Claim 13, **characterized in that** the first layer and/or the second layer has/have sacrificial-layer etching holes (170), the sacrificial-layer etching holes being closed by an oxide or a filling material.

16. Micromechanical component according to one of Claims 12 to 15, **characterized in that** the component can be used as an absolute pressure sensor or a relative pressure sensor or a microphone or an acceleration sensor, it being provided in particular that the relative pressure sensor or the microphone has a cavity introduced from the rear side of the semiconductor substrate and/or the first electrode has at least one through-hole.

17. Micromechanical component according to Claim 11, **characterized in that** the buried cavity is at least partially surrounded by an edge region (130), it being provided that the doping of the edge region and the doping of the first and second electrodes differ.

## Revendications

1. Procédé de fabrication d'un convertisseur capacitif micromécanique de pression, la fabrication comportant les étapes de traitement micromécanique de surface qui consistent à :
former une première électrode à l'intérieur d'un substrat semi-conducteur (100) en silicium, notamment en silicium dopé,
former une structure monocristalline en grille pour réaliser une deuxième électrode (120, 125) au-dessus d'une première partie (110) gravée de manière à être rendue poreuse dans le substrat semi-conducteur de silicium,
appliquer une couche d'épitaxie (150) sur le substrat semi-conducteur (100) de silicium et sur la deuxième électrode (120, 125),
appliquer une première couche (160) sur la couche d'épitaxie (150),
former une caverne en creux (115) entre la première partie (110) située entre la première et la deuxième électrode et
former une membrane (220) sur la deuxième électrode (120, 125) au-dessus de la première partie poreuse (110) en séparant la couche d'épitaxie (155) située sur la deuxième électrode de la couche d'épitaxie (150) située sur le substrat semi-conducteur en recourant à une opération de gravure, en prévoyant que la séparation forme entre la membrane et le substrat semi-conducteur une liaison mécanique flexible au moyen de la première couche (160).

2. Procédé de fabrication d'un convertisseur capacitif micromécanique de pression selon la revendication 1, **caractérisé en ce que** la mise en contact de la deuxième électrode s'effectue en recourant à un matériau d'épitaxie conducteur pour la couche d'épitaxie (155).

3. Procédé selon la revendication 1, **caractérisé en ce qu'**il prévoit comme opération de gravure une gravure en phase gazeuse, en particulier par ClF₃ ou SF₆.

4. Procédé selon la revendication 1, **caractérisé en ce que** la couche d'épitaxie présente sur la bordure de la caverne une topologie qui prévoit en particulier que la première couche appliquée sur la couche d'épitaxie présente également une topologie dans la bordure de la caverne.

5. Procédé de fabrication d'un convertisseur capacitif micromécanique de pression selon la revendication 1, **caractérisé en ce que** la caverne (115) est formée par
une opération de gravure isotrope,
un déplacement thermique ou
l'enlèvement du matériau semi-conducteur de silicium rendu poreux dans la première partie (110).

6. Procédé de fabrication d'un convertisseur capacitif micromécanique de pression selon la revendication 5, **caractérisé en ce que** la deuxième électrode (120, 125) est formée par déplacement thermique de la structure en grille non rendue poreuse par gravure du matériau semi-conducteur ou par formation d'une couche conductrice sur la structure en grille.

7. Procédé de fabrication d'un convertisseur capacitif micromécanique de pression selon les revendications 1 ou 5, **caractérisé en ce que** dans la première couche (160), des trous (170) de gravure de couche sacrifiée, par lesquels la membrane ou la deuxième électrode sont séparées du substrat semi-conducteur au moins au moyen d'une opération de gravure, sont formés dans la partie latérale de la membrane, en prévoyant en particulier que l'opération de gravure sépare de plus la couche d'épitaxie située au-dessus de la caverne de la couche d'épitaxie située au-dessus du substrat semi-conducteur.

8. Procédé de fabrication d'un convertisseur capacitif micromécanique de pression selon la revendication 1, **caractérisé en ce qu'**une deuxième couche (190), en particulier en polysilicium, est appliquée sur la première couche située au-dessus de la bordure de la membrane, en prévoyant que la deuxième couche soit structurée sous la forme d'une suspension élastique (190) de la membrane (220) dans au moins une partie de la bordure de la membrane et en prévoyant en particulier que la deuxième couche soit structurée en plusieurs éléments non reliés les uns les autres et spatialement séparés qui montent au moyen de la suspension élastique ainsi formée la membrane ou la deuxième électrode à déplacement au-dessus de la caverne,
des trous de gravure de couche sacrifiée étant prévus pour l'opération de gravure dans la première et la deuxième couche, en prévoyant en particulier que les trous (170) de gravure de couche sacrifiée soient fermés après l'opération de gravure par une oxydation et/ou par apport d'un matériau de comblement.

9. Procédé selon les revendications 7 ou 8, **caractérisé en ce que** la caverne est ouverte par le côté arrière du substrat semi-conducteur, en particulier par une opération de formation de tranchée.

10. Procédé de fabrication d'un convertisseur capacitif micromécanique de pression selon la revendication 8, **caractérisé en ce que** la mise en contact de la deuxième électrode s'effectue par l'intermédiaire de la suspension élastique (190) en prévoyant en particulier que la suspension élastique présente du polysilicium.

11. Composant micromécanique fabriqué selon l'une des revendications 1 à 10 et présentant
une première électrode à l'intérieur d'un substrat semi-conducteur (100) de silicium, notamment de silicium dopé,
une membrane (220) qui présente une couche d'épitaxie (155) et une deuxième électrode (120, 125),
une première couche (160) située sur la membrane et sur le substrat semi-conducteur,
une caverne (115) creusée entre la première et la deuxième électrode,
la membrane située au-dessus de la première électrode étant maintenue à déplacement au moyen de la première couche et la deuxième électrode (155) étant maintenue à distance latérale du substrat semi-conducteur (150).

12. Composant micromécanique selon la revendication 11, **caractérisé en ce que** la mise en contact de la deuxième électrode s'effectue par l'intermédiaire de la couche d'épitaxie (155) conductrice.

13. Composant micromécanique selon la revendication 12, **caractérisé en ce qu'**une deuxième couche (190), en particulier en polysilicium, est située sur la première couche au-dessus de la bordure de la membrane et présente la forme d'une suspension élastique de la membrane dans au moins une partie de la bordure de la membrane, en prévoyant en particulier que la deuxième couche est structurée en plusieurs éléments non reliés les uns aux autres et délimités spatialement, qui forment ensemble la suspension élastique de la membrane ou de la deuxième électrode et/ou qui permettent la mise en contact électrique de la deuxième électrode.

14. Composant micromécanique selon la revendication 13, **caractérisé en ce que** la première couche présente une topologie dans la bordure de la caverne.

15. Composant micromécanique selon la revendication 13, **caractérisé en ce que** la première et/ou la deuxième couche présentent des trous (170) de gravure de couche sacrifiée, les trous de gravure de couche sacrifiée étant fermés par un oxyde ou un matériau de comblement.

16. Composant micromécanique selon l'une des revendications 12 à 15, **caractérisé en ce que** le composant peut être utilisé comme détecteur de pression absolue, détecteur de pression relative, microphone ou détecteur d'accélération, en prévoyant en particulier que le détecteur de pression relative ou le microphone présentent une caverne ménagée par le côté arrière du substrat semi-conducteur et/ou que la première électrode présente au moins un trou de passage.

17. Composant micromécanique selon la revendication 11, **caractérisé en ce que** la caverne creusée est entourée au moins en partie par une bordure (130), en prévoyant que le dopage de la bordure et le dopage de la première et de la deuxième électrode sont différents.
